# EUROPEAN PATENT APPLICATION

(11) **EP 4 597 223 A1**
(43) Date of publication of application: **06.08.2025**
(21) Application number: 25151419.6
(22) Date of filing: 13.01.2025
(51) Int. Cl.: G03F 7/00, H01L 21/683, H01L 21/687, H01L 21/67

(54) **HOLDING MECHANISM AND EXPOSURE APPARATUS**

(30) Priority: 31.01.2024 JP 2024013017
(71) Applicant: Ushio Denki Kabushiki Kaisha, Tokyo 100-8150 (JP)
(72) Inventor: ISHIDA, Kenji, Tokyo, 100-8150 (JP)
(74) Representative: Maiwald GmbH

(57) **Abstract**

A holding mechanism includes a suction section (21), an elastic seal member (22), and a clamp mechanism (40). The suction section (21) has a suction surface (24) on which a workpiece is to be vacuum-suctioned. The elastic seal member (22) is disposed around the suction surface (24) such that at least part of the elastic seal member (22) is hidden by the workpiece in plan view when the suction surface (24) is viewed from above. The clamp mechanism (40) includes a clamp (41) that presses the workpiece such that the workpiece comes into contact with the elastic seal member (22), and drives the clamp (41) to press the workpiece when the workpiece is suctioned by the suction section (21).

## Description

### CROSS REFERENCE TO RELATED APPLICATIONS

This application claims the benefit of Japanese Priority Patent Application JP 2024-013017 filed January 31, 2024, the entire contents of which are incorporated herein by reference.

### Background

The present invention relates to a holding mechanism that holds a workpiece and to an exposure apparatus.

Conventional technologies of fixing a workpiece to a stage that vacuum-suctions a workpiece by a clamp have been known. For example, Japanese Patent Application Laid-open No. 2013-210432 discloses a workpiece fixing apparatus that includes a clamping section that fixes a workpiece to an installation base having a number of suction holes formed therein. This apparatus includes a clamping section in a width direction and a clamping section in a front-back direction so as to surround the installation base. In the installation base, the workpiece is suctioned through each suction hole, and the workpiece is pressed against the installation base by a bending rod provided in each clamping section (paragraphs [0032], [0035], and [0047] of the specification, Figs. 4 and 8, etc. of Japanese Patent Application Laid-open No. 2013-210432).

Even when a workpiece is clamped in such a manner, it is conceivable that the pressure to suction the workpiece is not reduced and the workpiece is not properly suctioned if there is a gap between the suction stage and the workpiece. For example, depending on the size, thickness, surface irregularities, warpage, undulation, and the like of the workpiece itself, a gap between the suction stage and the workpiece may easily occur, which may make it difficult to suction the workpiece. Therefore, there is a need for a technology capable of properly suctioning various workpieces.

In view of the circumstances as described above, it is desirable to provide a holding mechanism capable of properly suctioning various workpieces and an exposure apparatus.

### Summary

According to an embodiment of the present invention, there is provided a holding mechanism including a suction section, an elastic seal member, and a clamp mechanism.

The suction section has a suction surface on which a workpiece is to be vacuum-suctioned.

The elastic seal member is disposed around the suction surface such that at least part of the elastic seal member is hidden by the workpiece in plan view when the suction surface is viewed from above.

The clamp mechanism includes a clamp that presses the workpiece such that the workpiece comes into contact with the elastic seal member, and drives the clamp to press the workpiece when the workpiece is suctioned by the suction section.

In this holding mechanism, the elastic seal member is provided around the suction surface on which a workpiece is vacuum-suctioned. The elastic seal member is configured such that at least part of the elastic seal member is hidden by the workpiece in plan view when the suction surface is viewed from above. When the workpiece is suctioned, the workpiece is pressed by the clamp of the clamp mechanism such that the workpiece comes into contact with the elastic seal member. This makes it possible to prevent the occurrence of a gap that inhibits vacuum suction for the workpiece and to properly vacuum-suction various workpieces.

The clamp may press the workpiece at a position at which the workpiece and the elastic seal member overlap with each other in plan view.

The workpiece and the elastic seal member may each have a rectangular planar shape. In this case, the clamp may press the workpiece along at least one side of four sides of the workpiece, the four sides being outer edges of the workpiece.

The clamp mechanism may release an operation of the clamp to press the workpiece after suction for the workpiece by the suction section is completed and before processing is performed on the workpiece.

The clamp mechanism may be a mechanism that opens and closes the clamp to press the workpiece, and may execute an operation of opening the clamp in at least two steps.

The operation of opening the clamp may include a first opening operation of moving the clamp to a first position distant from the workpiece, and a second opening operation of moving the clamp to a second position more distant than the first position.

The clamp mechanism may execute the first opening operation after suction for the workpiece by the suction section is completed and before processing is performed on the workpiece, and may execute the second opening operation after the processing is executed.

The clamp mechanism may execute the first opening operation on the basis of a signal indicating that the suction for the workpiece by the suction section is completed or a signal indicating that the processing for the workpiece is started.

The processing may be an exposure process of exposing the workpiece by an exposure section that exposes a pattern onto the workpiece. In this case, the clamp mechanism may execute the second opening operation when the workpiece is moved away from an exposure position of the exposure section after the exposure process is performed on the workpiece.

A separation distance between the clamp and the workpiece at the first position may be 1 mm or less.

The clamp mechanism may execute an operation of closing the clamp all at once.

The suction section may include a circumferential section that surrounds the suction surface and is formed to be lower in level than the suction surface. In this case, the elastic seal member may be disposed in the circumferential section.

The suction section may include a base including a recess that supplies vacuum and a plurality of protrusions formed in the recess, and a suction plate including a plurality of through-holes and forming the suction surface by being attached above the recess.

According to an embodiment of the present invention, there is provided an exposure apparatus including an exposure section and a workpiece stage.

The exposure section exposes a pattern onto a workpiece.

The workpiece stage includes a suction section having a suction surface on which the workpiece is to be vacuum-suctioned, an elastic seal member disposed around the suction surface such that at least part of the elastic seal member is hidden by the workpiece in plan view when the suction surface is viewed from above, and a clamp mechanism that includes a clamp that presses the workpiece such that the workpiece comes into contact with the elastic seal member, and drives the clamp to press the workpiece when the workpiece is suctioned by the suction section.

The exposure section includes a light emission section that emits exposure light, a mask stage that holds a mask on which the pattern is formed, on an optical path of the exposure light, and a projection optical system that projects the exposure light onto the workpiece, the exposure light having passed through the mask.

As described above, according to the present invention, it is possible to properly suction various workpieces. Note that the effects described herein are not necessarily limited and may be any effect described in the present disclosure.

These and other objects, features and advantages of the present disclosure will become more apparent in light of the following detailed description of best mode embodiments thereof, as illustrated in the accompanying drawings.

### Brief Description of Drawings

Fig. 1 is a schematic view showing a configuration example of an exposure apparatus including a workpiece stage according to an embodiment of the present invention;
Figs. 2A and 2B are schematic views showing a configuration example of the workpiece stage except for a clamp mechanism;
Figs. 3A and 3B are schematic views showing a configuration example of the clamp mechanism;
Figs. 4A and 4B are schematic views showing a state in which the clamp mechanism shown in Figs. 3A and 3B clamps a workpiece W;
Fig. 5 is a flowchart showing an example of an exposure sequence by the exposure apparatus;
Figs. 6A, 6B, 6C, and 6D are schematic views showing operation examples of the clamp mechanism in the exposure sequence; and
Fig. 7 is a schematic view showing a configuration example of a seal unit including an elastic seal member.

### Detailed Description of Embodiments

Hereinafter, embodiments according to the present invention will be described with reference to the drawings.

### Configuration of Exposure Apparatus

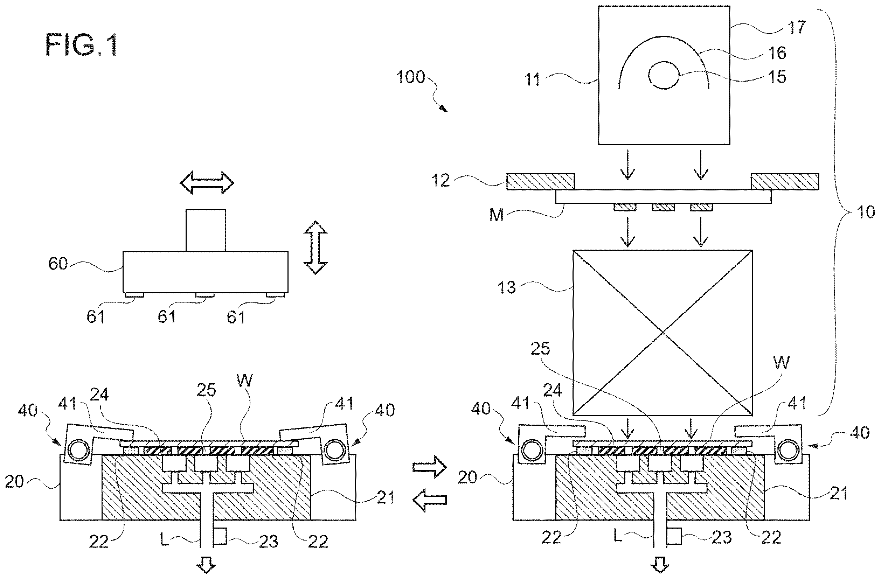

Fig. 1 is a schematic view showing a configuration example of an exposure apparatus including a workpiece stage according to an embodiment of the present invention. An exposure apparatus 100 is an apparatus that exposes a flat plate-like workpiece W to light. The exposure apparatus 100 includes an exposure section 10 and a workpiece stage 20. The exposure section 10 includes a light irradiation section 11, a mask M, a mask stage 12, and a projection optical system 13.

The workpiece W is a printed circuit board, for example. Hereinafter, in the workpiece W, a surface that is subjected to exposure will be referred to as an exposure surface of the workpiece W, and the surface opposite to the exposure surface will be referred to as a back surface of the workpiece W. The exposure surface of the workpiece W loaded into the exposure apparatus 100 is coated with a sensitive material such as photoresist. The thickness of the workpiece W is not particularly limited, but a thin workpiece W having a thickness of 0.2 mm or the like may be used, for example.

The light irradiation section 11 emits exposure light. The light irradiation section 11 includes a lamp 15, a mirror 16, and a lamp house 17. The lamp 15 is a light source for exposure that emits exposure light including ultraviolet rays. The mirror 16 reflects the exposure light emitted from the lamp 15 in a predetermined output direction. The lamp house 17 is an enclosure that houses the lamp 15 and the mirror 16. Here, a case will be described, in which the light source of the light irradiation section 11 is the lamp 15; however, examples of the light source to be used may include a light-emitting diode (LED) and a laser light source. Additionally, the wavelength and bandwidth of the exposure light are also not limited. In this embodiment, the light irradiation section 11 corresponds to a light emission section that emits exposure light.

A pattern such as a circuit pattern to be exposed (transferred) onto the workpiece W is formed on the mask M. The mask stage 12 holds the mask, onto which the pattern is formed, on an optical path of the exposure light. The projection optical system 13 projects the exposure light that has been transmitted through the mask M onto the flat plate-like workpiece W. For example, the projection optical system 13 is configured as a reduction optical system in which the pattern of the mask M is reduced in size to form an image on the front surface of the workpiece W.

In the exposure apparatus 100, the light irradiation section 11, the mask M, the mask stage 12, and the projection optical system 13 constitute the exposure section 10 that exposes a pattern onto the workpiece W. Additionally, the workpiece stage 20 is a stage that holds the workpiece W at an exposure position of the exposure section 10. Note that in this embodiment the case where the exposure section 10 includes the projection optical system 13 will be described, but the present invention is also applicable to the case without the projection optical system 13. In this embodiment, the exposure process performed by the exposure section 10 is an example of processing for the workpiece W.

The workpiece stage 20 is a holding mechanism that vacuum-suctions and holds the flat plate-like workpiece W. The workpiece stage 20 includes a suction section 21, an elastic seal member 22, and a clamp mechanism 40. The suction section 21 has a suction surface 24 on which the workpiece W is vacuum-suctioned. The workpiece W is placed on the workpiece stage 20 with its back surface facing the suction surface 24.

The suction surface 24 includes a plurality of vacuum suction holes 25. Additionally, each vacuum suction hole 25 is connected to piping L for evacuation. For example, when the workpiece W is vacuum-suctioned, the piping L is connected to a vacuum pump. Further, when the vacuum suction for the workpiece W is released, gas (air etc.) for breaking the vacuum atmosphere is supplied to the piping L.

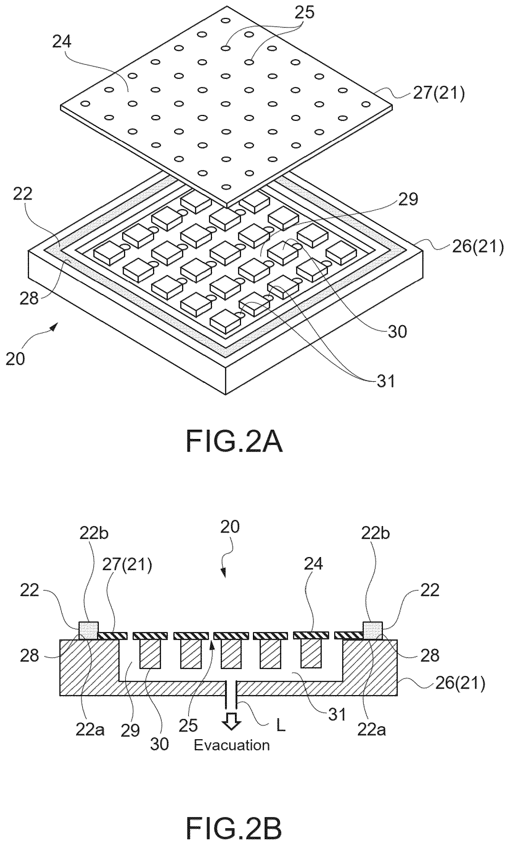

The elastic seal member 22 is a seal member (vacuum seal) made of an elastic body. The elastic seal member 22 is disposed around the suction surface 24 such that the workpiece W hides at least part of the elastic seal member22 in plan view when the suction surface 24 is viewed from above. In other words, the elastic seal member 22 is disposed at a position around the suction surface 24 and below the workpiece W and is configured to come into contact with the back surface of the workpiece W. Providing the elastic seal member 22 makes it less likely to generate a gap on the back surface side of the workpiece W and makes it possible to suppress the leakage of the vacuum atmosphere. Specific configurations of the workpiece stage 20 and the elastic seal member 22 will be described later with reference to Figs. 2A and 2B and the like.

The clamp mechanism 40 includes a clamp 41 that presses the workpiece W such that the workpiece W comes into contact with the elastic seal member 22. The clamp mechanism 40 drives the clamp 41 to press the workpiece Wwhen the workpiece W is suctioned by the suction section 21. This makes it less likely to generate a gap between the workpiece W and the elastic seal member 22 when the workpiece W is suctioned, and also makes it possible to properly vacuum-suction the workpiece W. Therefore, the clamp mechanism 40 functions as a vacuum suction assist mechanism that assists vacuum suction by the suction section 21.

Additionally, the workpiece stage 20 is provided with a suction sensor 23 for detecting the completion of the vacuum suction for the workpiece W. The suction sensor 23 is, for example, a pressure sensor that detects an evacuation pressure, and is mounted to the piping L that performs evacuation. Note that the configuration of the suction sensor 23 is not limited, and for example, the suction sensor 23 may determine whether or not the vacuum suction is completed by a ranging sensor or the like that detects the degree of flatness of the workpiece W.

In this embodiment, the workpiece stage 20 is connected to a moving mechanism, which is not shown in the figure, and moves between a delivery position and an exposure position for the workpiece W. At the delivery position, the workpiece W is delivered between a workpiece handler 60, which will be described later, and the workpiece stage 20. At the exposure position, the workpiece W is disposed immediately below the projection optical system 13. For the moving mechanism, for example, a mechanism that moves the workpiece stage 20 along a rail, and a mechanism that holds and moves the workpiece stage 20 using an arm or the like are used. Other configurations of the moving mechanism are not limited.

Fig. 1 shows the configuration in which the workpiece stage 20 moves back and forth between the delivery position and the exposure position to load and unload the workpiece W at the same delivery position. For example, the left part of Fig. 1 shows a state in which the workpiece stage 20 is moved to the delivery position, and the right part of Fig. 1 shows a state in which the workpiece stage 20 is moved to the exposure position. Note that the delivery position for loading (loading position) and the delivery position for unloading (unloading position) may differ from each other. In this case, the workpiece W is delivered in one direction in the order of the loading position, the exposure position, and the unloading position.

The workpiece handler 60 is a transport mechanism that loads the workpiece W to the workpiece stage 20 or unloads the workpiece W from the workpiece stage 20. In the example shown in Fig. 1, one workpiece handler 60 loads and unloads the workpiece W to and from the workpiece stage 20 that has moved to the delivery position. Note that if the loading position and the unloading position are different from each other, a workpiece handler 60 for loading and a workpiece handler 60 for unloading may be respectively provided.

The workpiece handler 60 includes a plurality of suction pads 61. The suction pad 61 is a pad that holds a contacted object by vacuum suction. The workpiece handler 60 causes the plurality of suction pads 61 to come into contact with the exposure surface of the workpiece W and suctions the workpiece W, thereby holding the workpiece W. Additionally, the workpiece handler 60 cancels the suction by the suction pads 61 to release the workpiece W.

In the example shown in Fig. 1, the workpiece handler 60 is disposed, with the plurality of suction pads 61 facing downward, above the workpiece stage 20 that has moved to the delivery position. Additionally, the workpiece handler 60 is configured to be movable in the vertical direction. For example, when the workpiece stage 20 moves to the delivery position, the workpiece handler 60 moves downward and delivers the workpiece W. Note that the configuration of the workpiece handler 60 is not limited, and for example, any mechanism that can load and unload the workpiece W may be used.

The exposure apparatus 100 including the workpiece stage 20, the moving mechanism of the workpiece stage 20, and the workpiece handler 60 are controlled by a control apparatus, illustration of which is omitted. Note that a dedicated control unit for controlling each section may be provided.

### Configuration of Workpiece Stage

In this embodiment, a case where the planar shape of the workpiece W is rectangular will be mainly described. Thus, the workpiece stage 20 is configured to vacuum-suction a rectangular workpiece W. Here, the workpiece W having a rectangular planar shape means that the outline of the planar shape of the workpiece W is rectangular. Therefore, the four sides forming the outer edge of the workpiece W may include a portion cut inwardly (cutout), a portion protruding outwardly, and the like.

Note that the planar shape of the workpiece W is not limited. For example, even if the planar shape of the workpiece W is a shape other than the rectangular shape (circular shape, polygonal shape, or the like), the present invention can be applied by forming the sections of the workpiece stage 20, such as the suction section 21, the elastic seal member 22, and the clamp mechanism 40, according to the planar shape of the workpiece W.

Figs. 2A and 2B are schematic views showing a configuration example of the workpiece stage 20 except for the clamp mechanism 40. Fig. 2A and Fig. 2B schematically show an exploded perspective view and a cross-sectional view of the portions of the workpiece stage 20 excluding the clamp mechanism 40, i.e., the suction section 21 and the elastic seal member 22. Hereinafter, the side of the workpiece stage 20, on which the workpiece W is held (the side to be irradiated with exposure light) will be referred to as an upper side of the workpiece stage, and the opposite side thereof will be referred to as a lower side.

### Configuration of Suction Section

As shown in Fig. 2A, the suction section 21 includes a base 26 and a suction plate 27 attached to the base 26. A suction surface 24 is formed on the surface of the suction plate 27. The suction surface 24 is a planar region in which the workpiece W is held by vacuum suction, and is provided on the upper side of the workpiece stage 20. During vacuum suction, the workpiece W is held in such a way that it sticks to the suction surface 24. The suction section 21 also includes an attaching section 28 for attaching the elastic seal member 22.

The base 26 is a metal block that is to be the base of the suction section 21. The planar shape of the base 26 is a rectangular shape (in this case, substantially square) as viewed from above. The base 26 is typically made of an aluminum block subjected to electroless nickel plating on its surface; however, a base that is subjected to alumite treatment or welded with ceramics may also be used. The material of the base 26 may also be metal such as iron or copper.

A recess 29 is formed at the center portion of the upside surface of the base 26, and a plurality of protrusions 30 on which the suction plate 27 is to be placed is formed in the recess 29. Additionally, the recess 29 is provided with a plurality of vacuum introduction channels 31 through which vacuum is introduced into the recess 29 from a vacuum system (piping L) attached to the base 26. The vacuum or air supplied to the piping L is introduced to the recess 29 through the vacuum introduction channels 31. In such a manner, the base 26 includes the recess 29, to which the vacuum is supplied, and the plurality of protrusions 30 formed in the recess 29.

Additionally, the upside surface of the base 26 is finished as a precision flat surface. Here, the upside surface is a surface formed by the upper surfaces of the protrusions 30 and the upper outer circumferential surface of the base 26 (the surface surrounding the edge of the recess 29). In other words, the upper surfaces of the protrusions 30 and the outer circumferential surface of the base 26 have the same height, and their degree of flatness is approximately 10 µm. The upside surface of the base 26 is a surface on which the suction plate 27 is disposed.

The suction plate 27 is a thin plate member that has a size to completely cover the recess 29 of the base 26 and is made of a material having some flexibility to follow the upside surface of the base 26. For example, a stainless steel plate having a thickness of 0.3 mm is used as the suction plate 27. Note that the thickness and material of the suction plate 27 are not limited to the above and may be appropriately selected according to the size of the recess 29, for example. As shown in Fig. 2A, the suction plate 27 has the suction surface 24 and the plurality of vacuum suction holes 25.

The suction surface 24 is a flat surface on which the workpiece W is held during vacuum suction. The suction surface 24 is formed as a surface having a high degree of flatness so as to hold the workpiece Wflatly. Therefore, the suction plate 27 can be a high-flatness suction plate in which the suction surface 24 having a high degree of flatness is formed. The suction plate 27 is attached above the recess 29 of the base 26 with the suction surface 24 facing upward. For example, through-holes through which screws are to be inserted are provided at the four corners of the suction plate 27, and the suction plate 27 is fixed to the base 26 with the screws. Note that other fixtures other than the screws may be used to fix the plate.

The plurality of vacuum suction holes 25 are through-holes formed in the suction surface 24. The vacuum suction holes 25 are provided over the entire region overlapping with the recess 29 of the base 26 in plan view when viewed from above. Here, the vacuum suction holes 25 each having a predetermined diameter are provided in a grid pattern at regular intervals. Note that the positions of the vacuum suction holes 25 are set so as not to coincide with the positions of the protrusions 30 of the base 26. When the suction plate 27 is attached to the base 26 and vacuum is supplied to the base 26, the vacuum is introduced to the recess 29 of the base 26 as described above, and the vacuum is also supplied to the vacuum suction holes 25 of the suction plate 27 that covers the recess 29. This enables the workpiece W to be vacuum-suctioned.

In the exposure apparatus 100, a plurality of suction plates 27 are prepared according to the size and shape of the workpiece W or the position of a cutout or through-hole provided in the workpiece W. The number, hole diameter, shape, and arrangement of the vacuum suction holes 25 provided to each suction plate 27, the region where the vacuum suction holes 25 are provided, and the like are set depending on the workpiece W.

For example, in the example shown in Fig. 2A, circular holes are provided as the vacuum suction holes 25, but the present invention is not limited thereto. Through-holes of various shapes, such as rectangular holes and flat oval holes, can be provided as the vacuum suction holes 25. Additionally, the size (diameter etc.) and arrangement of the vacuum suction holes 25 can also be freely set in the surface of one suction plate 27 depending on the size, softness, warpage, or the like of the workpiece W. The suction plate 27 is configured in such a manner, which makes it possible to select an optimal suction plate 27 depending on the type of workpiece W to be processed and to hold the workpiece W by suction.

### Configuration of Elastic Seal Member

The elastic seal member 22 is made of, for example, a rubber sponge and is annularly disposed so as to surround the suction surface 24. As the material of the elastic seal member 22, a low-repulsion elastic material such as ethylene propylene diene monomer rubber (EPDM), fluorine rubber, or urethane is used. For example, a material capable of compression-deforming such that the flatness of the workpiece W is not impaired during vacuum suction for the workpiece W is appropriately selected. Additionally, the elastic seal member 22 is sometimes referred to as a flex seal. Note that the elastic seal member 22 may be entirely made of a similar material or may be made of partially different materials.

The elastic seal member 22 has a lower surface 22a and an upper surface 22b. In this embodiment, the elastic seal member 22 is attached to the base 26. Specifically, the elastic seal member 22 is attached to the base 26 so as to surround the suction plate 27 with the lower surface 22a being in contact with the upside surface of the base 26. In other words, the annular region surrounding the suction plate 27 on the upside surface of the base 26 is the attaching section 28 to which the lower surface 22a of the elastic seal member 22 is attached.

As shown in Fig. 2B, the position of the attaching section 28 is lower in level than the suction surface 24 because of the thickness of the suction plate 27. In such a manner, the attaching section 28 surrounds the suction surface 24 and is formed to be lower in level than the suction surface 24. In this embodiment, the attaching section 28 corresponds to a circumferential section.

Additionally, the elastic seal member 22 is configured such that the upper surface 22b protrudes to be higher in level than the suction surface 24 with the lower surface 22a being attached to the attaching section 28. Providing the portion protruding from the suction surface 24 in such a manner makes it easy to bring the upper surface 22b of the elastic seal member 22 and the back surface of the workpiece W into contact with each other. Additionally, in a state in which vacuum suction for the workpiece W is completed, the elastic seal member 22 is crushed and compression-deformed by the workpiece W attracted to the suction surface 24, thereby functioning as a leak-suppression mechanism that suppresses vacuum leakage.

The planar shape of the elastic seal member 22 is configured in a manner that the region where the elastic seal member 22 and the workpiece W come into contact with each other is an annularly closed region. In other words, the workpiece W and the elastic seal member 22 are configured so as to come into contact with each other over the entire circumference. In this embodiment, the planar shape of the elastic seal member 22 is also configured to be rectangular according to the rectangular workpiece W.

The elastic seal member 22 is configured to be entirely hidden by the workpiece W in plan view when the suction surface 24 is viewed from above. In this case, for example, the outer circumferential shape of the elastic seal member 22 may be set to have the same shape and size as the outer circumferential shape of the workpiece W or may be set to fit inside of the outer circumference of the workpiece W. Additionally, the elastic seal member 22 may be configured to be partially hidden by the workpiece W in plan view when the suction surface 24 is viewed from above. In this case, for example, the elastic seal member 22 is configured such that the outer circumference of the workpiece W falls between the inner circumference and the outer circumference of the elastic seal member 22. In addition to the above, the shape of the elastic seal member 22 may be appropriately set in the range where the workpiece W can be properly vacuum-suctioned.

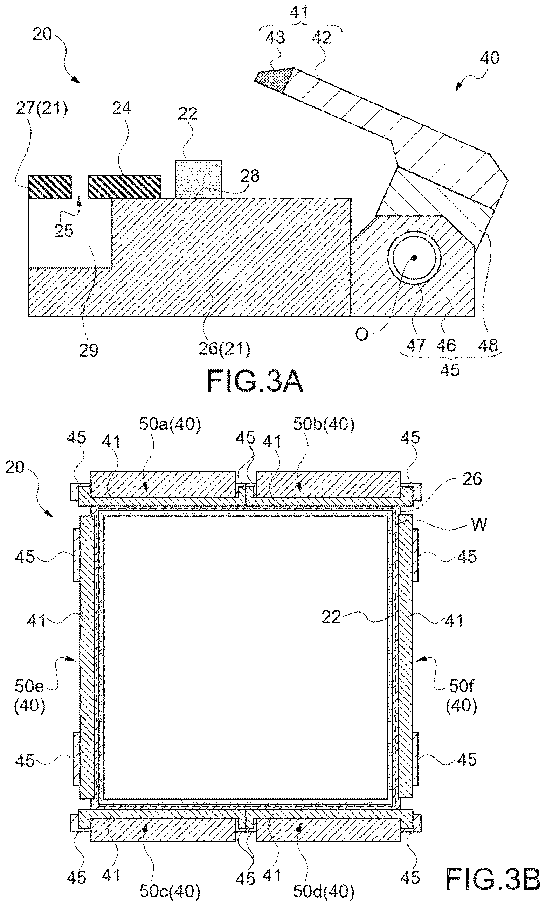

In this configuration in which the elastic seal member 22 is attached to the attaching section 28 of the base 26, the position of the suction surface 24 is higher than the position of the surface to which the elastic seal member 22 is attached, i.e., the upside surface of the base 26. Hence, the thickness of the suction plate 27 cancels out the thickness of the elastic seal member 22 during compression. Therefore, there is no need to provide an additional step or the like on the upside surface of the base 26 in order to cancel out the thickness of the elastic seal member 22 during compression. This makes it possible to simplify the configuration of the base 26 and reduce manufacturing costs. Note that in the example shown in Figs. 3A and 3B the attaching section 28 is provided at the same height position as the surface on which the base 26 supports the suction plate 27, but the height position of the attaching section 28 may be discretionally set as long as it is lower than the suction surface 24. For example, a groove-like attaching section 28 that is lower in level than the surface that supports the suction plate 27 may be formed. Additionally, the height position of the attaching section 28 may be set to be higher than the surface that supports the suction plate 27 and also lower than the suction surface 24. In addition to the above, the height position of the attaching section 28 may be set in accordance with the characteristics such as the thickness and the crushability of the elastic seal member 22 such that the thickness of the elastic seal member 22 can be properly cancelled out.

### Configuration of Clamp Mechanism

Figs. 3A and 3B are schematic views showing a configuration example of the clamp mechanism 40. Fig. 3A is a schematic cross-sectional view of the clamp mechanism 40 partially enlarged. Fig. 3B is a schematic plan view of the entire workpiece stage 20 including the clamp mechanism 40 as viewed from above. Fig. 3A and Fig. 3B show a state in which no workpiece W is placed on the workpiece stage 20 and the clamp mechanism 40 is opened. Note that Fig. 3B schematically shows the outer shape of the workpiece W by the dotted line.

The clamp mechanism 40 includes a clamp 41 that presses the workpiece W and a drive section 45 that drives the clamp 41. The clamp mechanism 40 includes a plurality of clamps 41 and a plurality of drive sections 45 provided to the respective clamps 41. In the following, a unit including a clamp 41 and a drive section 45 that drives the clamp 41 will be referred to as a clamp unit 50. Therefore, the clamp mechanism 40 includes a plurality of clamp units 50. Additionally, the drive section 45 of each clamp unit 50 is controlled by, for example, a control apparatus that controls the overall operation of the exposure apparatus 100.

As shown in Fig. 3B, in this embodiment, clamp units 50a to 50f are provided so as to surround the suction section 21 (the base 26) along the respective sides of the rectangular workpiece W. The clamp units 50a and 50b are adjacently disposed at the upper part of the base 26 in the figure, the clamp units 50c and 50d are adjacently disposed at the lower part of the base 26 in the figure, and the clamp units 50e and 50f are adjacently disposed at the right part and left part of the base 26 in the figure.

The clamp units 50a and 50b (the clamp units 50c and 50d) press a side of the upper part (a side of the lower part) of the workpiece W. In such a manner, a plurality of clamp units 50 may be provided to one side of the workpiece W. The clamp units 50e and 50f individually press a side of the left part of the workpiece W and a side of the right part of the workpiece W, respectively. Note that the clamp units 50a and 50b (the clamp units 50c and 50d) may be configured as a single clamp unit 50. Additionally, each clamp unit 50 includes the drive sections 45 at the both ends of the clamp 41. The clamp units 50a to 50d are different from the clamp units 50e and 50f in the planar shape of the clamp 41 and the position of the drive section 45, but the clamp units 50a to 50f have the same basic configuration.

As shown in Fig. 3A, the clamp 41 includes a clamp main body 42 and a contact portion 43. The clamp main body 42 is a plate-like structure member that extends in one direction. The contact portion 43 is provided at one end side of the clamp main body 42 along the longitudinal direction. Additionally, the clamp main body 42 is fixed to a rotary member 48 of the drive section 45, which will be described later, on the opposite side of the contact portion 43. In such a manner, the clamp 41 has a cantilever structure as a whole.

The clamp main body 42 is made of, for example, a metal material such as aluminum or stainless steel. Additionally, the clamp main body 42 may be configured in combination of a metal material and a resin material. For example, the use of a resin material at the junction with the contact portion 43 makes it easy to fix the contact portion 43. Additionally, as shown in Fig. 3A, the thickness may be increased at the junction with the rotary member 48, or the root portion of the cantilever at which stress is concentrated when the workpiece W is pressed may be reinforced. In addition to the above, the structure and material of the clamp main body 42 are not limited.

The contact portion 43 is a portion of the clamp 41 that comes into contact with the workpiece W. As the contact portion 43, for example, an elastic member such as rubber is used. This makes it possible to avoid a situation in which the workpiece W is damaged due to excessive concentration of force. Additionally, the contact portion 43 is configured, for example, such that its thickness decreases toward the tip that comes into contact with the workpiece W. This makes it easy for the contact portion 43 to be elastically deformed when the contact portion 43 presses the workpiece W, thereby dispersing the concentration of force on the workpiece W. In addition to the above, the structure and material of the contact portion 43 are not limited.

The drive section 45 is a mechanism that mechanically moves the clamp 41 so as to press the workpiece W. For example, one clamp unit 50 includes one or more drive sections 45 (typically, two drive sections 45). As shown in Fig. 3A, the drive section 45 includes a seating 46, a shaft portion 47, and the rotary member 48. Additionally, the drive section 45 includes a drive mechanism that moves the rotary member 48, the illustration of which is omitted.

The seating 46 is a member that supports the shaft portion 47 and the rotary member 48 and is fixed to the circumference of the main body of the workpiece stage 20 (the base 26). The seating 46 is fixed to the base 26, for example, by screws. Alternatively, the seating 46 may be formed integrally with the base 26. Further, a through-hole into which the shaft portion 47 is fitted is formed in the seating 46.

The shaft portion 47 supports the rotary member 48 so as to be rotatable about a predetermined rotation axis O. The shaft portion 47 is, for example, a columnar member (typically, cylindrical member) that passes through both the seating 46 and the rotary member 48. Additionally, for example, a columnar member configured to be fixed to one of the rotary member 48 and the seating 46 and to pass through the other one of the rotary member 48 and the seating 46 may be used as the shaft portion 47. Further, when the shaft portion 47 is formed, a bearing such as a ball bearing may be used.

The rotation axis O of the shaft portion 47 is set, for example, in a direction in which the clamp 41 extends. Additionally, the rotation axes O of the respective drive sections 45 provided in one clamp unit 50 are configured to coincide with each other. In Fig. 3A, the direction passing through the center of the shaft portion 47 to be orthogonal to the plane of the figure is the rotation axis O. Additionally, in Fig. 3B, the rotation axis O of each clamp unit 50 is set in the direction along each side of the base 26.

The rotary member 48 is connected to the clamp 41 and rotates about the rotation axis O, thus driving the clamp 41. The operation of rotating the rotary member 48 is performed by the drive mechanism. Note that the rotary member 48 is configured to rotate in the angle range set in advance.

In Fig. 3A, when the rotary member 48 rotates clockwise (to the right), the clamp 41 moves away from the suction surface 24 and the elastic seal member 22. This is the operation of opening the clamp 41 (opening operation). Conversely, when the rotary member 48 rotates counterclockwise (to the left), the clamp 41 approaches the suction surface 24 and the elastic seal member 22. This is the operation of closing the clamp 41 (closing operation). In such a manner, the clamp mechanism 40 is a mechanism that opens and closes the clamp 41 to press the workpiece W.

The state shown in Fig. 3A is a state in which the rotary member 48 is rotated clockwise to the maximum angle, that is, a state in which the clamp 41 is opened to the maximum. When the workpiece stage 20 is viewed from above in this state (Fig. 3B), the region surrounded by the clamps 41 of the clamp units 50 is wider than the workpiece W. In other words, the state in which the clamps 41 are opened to the maximum is a state that allows the workpiece W to be loaded and unloaded. In the following, the position of the clamp 41 in the state where the clamp 41 is opened to the maximum will be referred to as an initial position.

Additionally, the maximum angle for the operation of closing the clamp 41 may be set. The maximum angle for the closing operation is set such that the workpiece W can be pressed by the clamp 41 until at least the workpiece W is held flatly along the suction surface 24. For example, the angle at which the tip of the contact portion 43 of the clamp 41 is located at the same height position as the upper surface of the suction surface 24 or the base 26 is set as the maximum angle for the closing operation.

The drive mechanism that drives the clamp 41 is disposed along the side surface or back surface of the base 26 and rotates the rotary member 48 to open and close the clamp 41. The force to press the workpiece W when the clamp 41 is closed is, for example, approximately 100 N per clamp unit 50. As a matter of course, the force to press the workpiece W is not limited and may be appropriately set according to the characteristics (thickness and material) and the like of the workpiece W and the elastic seal member 22.

The drive mechanism is configured, for example, in combination of an air cylinder and a link mechanism. In this configuration, the piston motion of the air cylinder is converted into the motion to rotate the rotary member 48 via the link mechanism. Such a drive mechanism can be compactly configured, for example, along the side surface or back surface of the workpiece stage 20 (the base 26). Additionally, the air cylinder does not generate heat, for example, like an electrically-operated power source, and can avoid deformation or the like of the base 26 and other parts due to heat generation.

Note that an electrically-operated motor, a linear actuator, or the like may be used as a power source. Additionally, as the mechanism for rotating the rotary member 48, a gear mechanism or the like may be used other than the link mechanism. In addition to the above, the specific configuration of the drive mechanism is not limited, and it is possible to use any drive mechanism that achieves a desired clamp operation.

### Clamp for Workpiece W

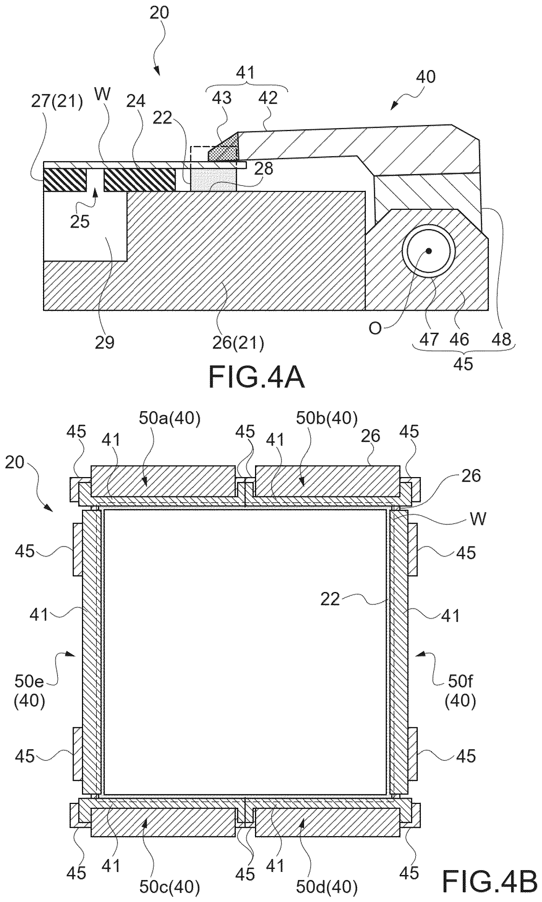

Figs. 4A and 4B are schematic views showing a state in which the clamp mechanism 40 shown in Figs. 3A and 3B clamps the workpiece W. A cross-sectional view of Fig. 4A and a plan view of Fig. 4B show a state in which the workpiece W is placed on the workpiece stage 20 and the clamp mechanism 40 is closed to clamp the workpiece W. Note that Fig. 4B shows only the outer shape of the workpiece W by the dotted line similarly to Fig. 3B. Actually, since the workpiece W is placed, the elastic seal member 22 and the like located under the workpiece W are not seen. Additionally, Fig. 4A shows, by the dotted line, a cross-sectional shape of the elastic seal member 22 before the workpiece W is clamped.

It is assumed that the clamp 41 located at the initial position is closed with the workpiece W being placed on the workpiece stage 20. When the clamp 41 is closed, the rotary member 48 rotates such that the clamp 41 comes into contact with the workpiece W. For example, in Fig. 4A, the rotary member 48 rotates counterclockwise. In this case, the contact portion 43 of the clamp 41 first comes into contact with the exposure surface of the workpiece W, and further presses the workpiece W in the downward direction. The workpiece W pressed by the clamp 41 then comes into contact with the elastic seal member 22.

Thus, for example, even if the workpiece W has a warpage and the back surface of the workpiece W and the elastic seal member 22 are not in contact with each other, the workpiece W is pressed against the elastic seal member 22 when the clamp 41 is closed. In such a manner, the clamp 41 presses the workpiece W such that the workpiece W comes into contact with the elastic seal member 22. Note that if the workpiece W and the elastic seal member 22 are in contact with each other before the clamp 41 is closed, the workpiece W and the elastic seal member 22 are caused to more closely adhere to each other when the clamp 41 is closed.

The clamp mechanism 40 closes the clamp 41 to press the workpiece W when the workpiece W is suctioned by the suction section 21. For example, during the period from when the workpiece W is placed on the workpiece stage 20 to when the suction for the workpiece W is completed, the closing operation of closing the clamp 41 is performed. The closing operation may be executed before the suction for the workpiece W is started, or may be executed after the suction for the workpiece W is started. Additionally, the closing operation may be executed simultaneously with the timing at which the suction for the workpiece W is started.

Here, the timing at which the suction for the workpiece W is started is, for example, the timing at which evacuation through the piping L is started. Additionally, if the evacuation is continuously performed, for example, the timing at which the workpiece W is placed on the suction surface 24 is the timing at which the suction is started. Further, the timing at which the suction for the workpiece W is completed is, for example, the timing at which an evacuation pressure is reduced to a predetermined threshold value or lower. In other words, when the pressure of the vacuum suction for the workpiece W is sufficiently reduced, the suction for the workpiece W is assumed to be completed.

In such a manner, the clamp 41 is closed when the workpiece W is suctioned, so that a gap (vacuum leakage) can be prevented from being generated between the workpiece W and the elastic seal member 22 during evacuation, for example. In other words, the closing operation of the clamp 41 exhibits a contact assisting function between the workpiece W and the elastic seal member 22. This makes it possible to reduce an evacuation pressure in a short time and to shorten the time taken for vacuum suction. Additionally, pressing the workpiece W with warpage or undulation using the clamp 41 makes it possible to come into contact with the elastic seal member 22 reliably and to properly perform vacuum suction.

Additionally, in the closed state of the clamp 41, a downward-pressing force acts on the workpiece W from the tip of the clamp 41 (the contact portion 43). This makes it possible to not only bring the workpiece W and the elastic seal member 22 into contact with each other but also give the force to crush the elastic seal member 22. As a result, the elastic seal member 22 can be actively crushed, which improves sealing performance. This makes it possible, for example, to improve the degree of vacuum attained in vacuum suction and to shorten the time taken to reach the required degree of vacuum (pressure of a predetermined threshold value or lower).

Note that when the evacuation is performed in the closed state of the clamp 41, the elastic seal member 22 is crushed by receiving the force of the clamp 41 pushing the workpiece W and the force acting on the workpiece W due to the negative pressure. For example, in a state in which vacuum suction is completed, the force acting on the workpiece W due to the negative pressure is large enough to keep the elastic seal member 22 crushed even when the clamp 41 is opened.

In this embodiment, the clamp 41 is configured to press the workpiece W at the position where the workpiece W and the elastic seal member 22 overlap with each other in plan view when the suction surface 24 is viewed from above. In other words, the clamp mechanism 40 clamps the workpiece W on the elastic seal member 22. For example, as shown in Fig. 4A and Fig. 4B, the length or the like of the cantilever portion of the clamp main body 42 is set such that the tip of the clamp 41 (the contact portion 43) comes into contact with the workpiece W at the position facing the elastic seal member 22.

For example, when the clamp 41 presses the workpiece W outside or inside of the elastic seal member 22, a downward force is exerted on the workpiece W with the elastic seal member 22 as a fulcrum, which may cause deformation or damage to the workpiece W. In contrast, pressing on the elastic seal member 22 makes it possible to cause the force exerted by the clamp 41 on the workpiece W, and the force exerted by the elastic seal member 22 on the workpiece W to return from the crushed state, to act to be cancelled out. This makes it possible to satisfactorily avoid deformation or damage to the workpiece W.

Additionally, as shown in Fig. 4B, in this embodiment, the clamps 41 are configured to press the workpiece W along the four sides that are outer edges of the rectangular workpiece W. For example, in the rectangular workpiece W, the height position of the outer edge is varied to a large degree due to the warpage of the workpiece W, which makes it difficult to come into contact with the elastic seal member 22. Even in such a case, clamping all the sides makes it possible to sufficiently suppress the leakage during vacuum suction.

Note that the clamp 41 may press the workpiece W along at least one of the four sides that are outer edges of the workpiece W. For example, if a side or the like that is easily warp in the workpiece W is known, a configuration in which only that side is pressed can also be possible.

Additionally, when the workpiece W is pressed along each side of the workpiece W, it is not necessary to clamp the workpiece W at the position overlapping with the elastic seal member 22. For example, the workpiece W may be pressed along at least one of the four sides at the position overlapping with the elastic seal member 22. For example, if a side of the workpiece W that is easily damaged or deformed is known, a configuration in which that side of the workpiece W is pressed at the position overlapping with the elastic seal member 22 can also be possible.

Here, configurations for comparison with the workpiece stage 20 will be described. For example, as a vacuum suction stage for the workpiece W, the following configuration is assumed, in which the workpiece W is directly clamped onto the suction surface to perform vacuum suction without providing a vacuum seal like the elastic seal member 22 between the suction surface and the workpiece W. In this case, for example, depending on characteristics of the workpiece W (for example, thickness, material, surface irregularities, warpage, undulation, and the like of the workpiece W), a gap may be generated between the suction surface and the workpiece W even if the workpiece W is clamped.

Additionally, as the vacuum suction stage for the workpiece W, the following configuration is assumed, in which a vacuum seal like the elastic seal member 22 is provided between the suction surface and the workpiece W to perform vacuum suction without clamping the workpiece W. Even if the vacuum seal is provided in such a manner, the workpiece W and the vacuum seal do not always adhere to each other depending on the characteristics of the workpiece W, such as warpage. In other words, a gap may be generated between the workpiece W and the vacuum seal.

The gap between the member on the stage side and the workpiece W may be eliminated by adhesion of the workpiece W to the suction surface in the process of evacuation. However, the presence of such a gap may elongate the time taken to reach the degree of vacuum required for the vacuum suction for the workpiece W. Additionally, if the gap is not eliminated, this may make it difficult to obtain the required degree of vacuum and complete the vacuum suction for the workpiece W.

In the workpiece stage 20 according to this embodiment, the elastic seal member 22 and the clamp mechanism 40 are provided in addition to the suction section 21 that vacuum-suctions the workpiece W. The elastic seal member 22 can adhere to the workpiece W along the back surface of the workpiece W. Thus, for example, a gap is less likely to be generated as compared to the case where the workpiece W is directly placed on the suction surface 24. Additionally, the workpiece W is pressed by the clamp 41 of the clamp mechanism 40 such that the workpiece W comes into contact with the elastic seal member 22. This makes it possible to avoid a situation in which a gap is generated between the workpiece W and the elastic seal member 22 and to close the space in which evacuation is performed.

Additionally, the operation of pressing the workpiece W by the clamp 41 is executed when the workpiece W is suctioned by the suction section 21. This makes it possible to perform evacuation in a state in which the workpiece W and the elastic seal member 22 sufficiently adhere to each other and to sufficiently shorten the time taken to reach the degree of vacuum required for vacuum suction for the workpiece W. In other words, this makes it possible to shorten the takt time required for vacuum suction. Additionally, the workpiece W and the elastic seal member 22 sufficiently adhere to each other, which makes it possible to satisfactorily prevent the occurrence of a gap and to reliably vacuum-suction the workpiece W.

As described above, the workpiece W and the elastic seal member 22 are caused to come into contact with each other by the clamp mechanism 40 when the workpiece W is suctioned, which makes it possible to prevent the occurrence of a gap that inhibits vacuum suction. This makes it possible to properly vacuum-suction various workpieces W different in states such as the thickness, material, surface irregularities, warpage, and undulation.

Hereinafter, the position of the clamp 41 in a state in which the clamp 41 is closed to clamp the workpiece W will be referred to as a clamp position. The clamp position is, for example, the position of the clamp 41 in a state in which the force given from the drive mechanism to the clamp 41 (the force acting in the direction in which the clamp 41 is closed) and the reaction force received by the clamp 41 from the workpiece W (the force acting in the direction in which the clamp 41 is opened) balance out. The clamp position is, for example, the position corresponding to the thickness of the workpiece W, the degree of vacuum of vacuum suction, or the like.

### Opening Operation of Clamp

In this embodiment, the clamp mechanism 40 executes the operation of opening the clamp 41 in at least two steps. Here, the operation of opening the clamp 41 (the opening operation of the clamp 41) is, for example, the operation of opening the clamp 41, which is located at the clamp position, to the initial position. Therefore, the drive section 45 of the clamp mechanism 40 is configured to be capable of opening the clamp 41 from the clamp position to the initial position in a stepwise manner. This makes it possible to release the clamp on the workpiece W even if there is no space or the like for opening the clamp 41 to the initial position.

Specifically, the operation of opening the clamp 41 is performed in two steps. In other words, the operation of opening the clamp 41 includes a first opening operation of moving the clamp 41 to a first position distant from the workpiece W, and a second opening operation of moving the clamp 41 to a second position more distant than the first position. Here, the second position is the initial position at which the clamp 41 is opened to the maximum. Additionally, the first position is an intermediate position set halfway through the opening of the clamp 41 to the initial position. For example, in the workpiece stage 20 shown in the right part of Fig. 1, the clamp 41 is opened to the intermediate position.

The clamp mechanism 40 is configured to be capable of maintaining the state in which the clamp 41 is located at the intermediate position. For example, when the clamp 41 is opened from the clamp position, the clamp 41 is first opened from the clamp position to the intermediate position (first opening operation), and subsequently the clamp 41 is opened from the intermediate position to the initial position (second opening operation).

The drive mechanism to open the clamp 41 in two steps includes, for example, a mechanism using two air cylinders. This mechanism includes a main cylinder that opens and closes the clamp 41 between the clamp position and the initial position, and a sub-cylinder that inhibits the piston motion of the main cylinder in the middle. For example, when the first opening operation is performed, the sub-cylinder stops the main cylinder from extending or retracting midway such that the clamp 41 stopes at the intermediate position. Additionally, when the second opening operation is performed, the inhibiting action by the sub-cylinder is released and the main cylinder is extended and retracted to the end so as to open the clamp 41 to the initial position. This makes it possible to achieve a drive mechanism that enables two-stage opening operation and generates almost no heat.

Additionally, when a motor is used as the drive mechanism, it is possible to perform two-stage opening operation by controlling the rotation of the motor. In this case, it is also possible to easily perform, for example, multi-stage opening operation by electrically controlling the motor.

In this embodiment, after the vacuum suction for the workpiece W is completed, the workpiece W is exposed by the exposure apparatus 100 with the clamp 41 being opened to the intermediate position. In the following, an exposure sequence including a loading process, an exposure process, and an unloading process for the workpiece W will be described specifically.

### Operation of Exposure Apparatus

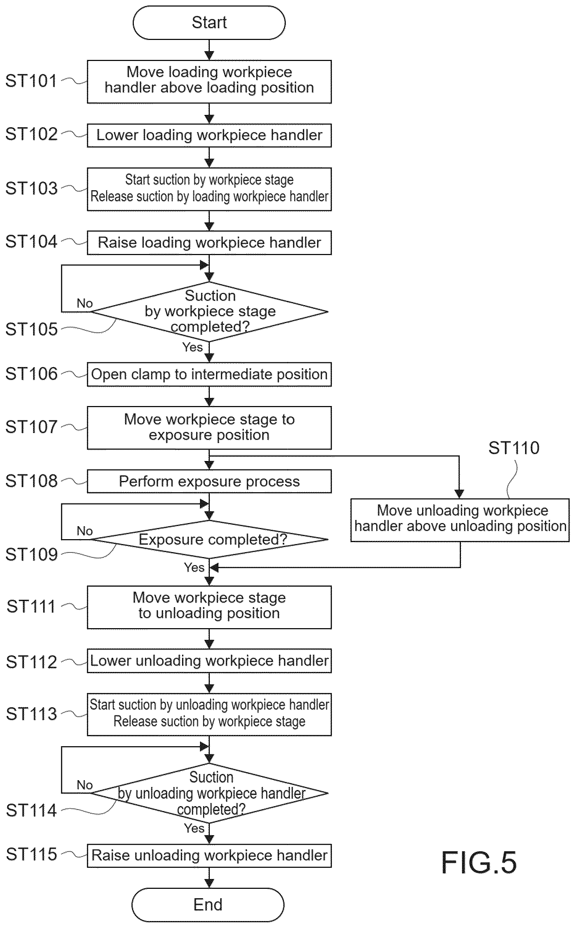

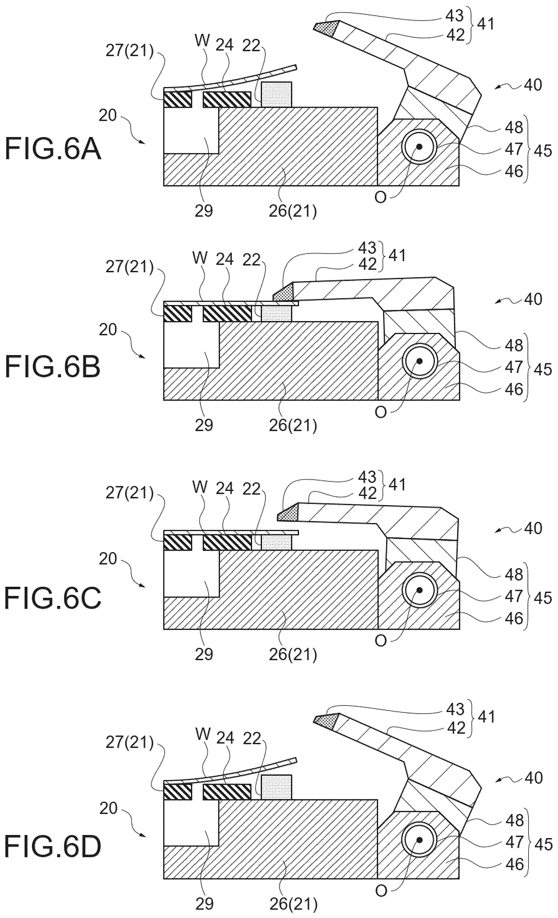

Fig. 5 is a flowchart showing an example of an exposure sequence by the exposure apparatus 100. Figs. 6A, 6B, 6C, and 6D are schematic views showing operation examples of the clamp mechanism 40 in the exposure sequence. The processes shown in Fig. 5 are, for example, executed by the exposure apparatus 100, the workpiece handler 60, and the moving mechanism described with reference to Fig. 1.

Here, the workpiece handler 60 that loads and unloads the workpiece W will be referred to as a loading workpiece handler 60 and an unloading workpiece handler 60. Additionally, the position of the workpiece stage 20 when the workpiece W is loaded and unloaded (delivery position) will be referred to as a loading position and an unloading position. Note that the same workpiece handler 60 may be used as the loading workpiece handler 60 and the unloading workpiece handler 60, or different workpiece handlers 60 may be used therefor. Additionally, as shown in Fig. 1, when the workpiece stage 20 performs a reciprocating operation, the loading position and the unloading position are the same position, but when the workpiece stage 20 moves in one direction, the loading position and the unloading position are different positions.

At the time of starting the exposure sequence, the workpiece W is held by suction on the exposure surface side by the loading workpiece handler 60. Additionally, the workpiece stage 20 is moved to the delivery position (loading position) where the workpiece W is to be loaded from the loading workpiece handler 60. In addition, the workpiece W is not placed on the workpiece stage 20, and the clamp 41 is opened to the initial position such that the workpiece W can be loaded.

First, the process of moving the loading workpiece handler 60 above the loading position is executed (Step 101). For example, the loading workpiece handler 60 suctions the workpiece W, on which the previous step of the exposure process has been performed, and moves from the position where the workpiece W has been suctioned to a position above the loading position. Next, the process of lowering the loading workpiece handler 60 is executed (Step 102). For example, the loading workpiece handler 60 is lowered until at least part of the workpiece W comes into contact with the suction surface 24 or the elastic seal member 22 of the workpiece stage 20, and then the workpiece W is placed on the workpiece stage 20.

Next, the process of starting the suction for the workpiece W by the workpiece stage 20 and also releasing the suction for the workpiece W by the loading workpiece handler 60 is executed (Step 103). This is the operation of delivering the workpiece W from the loading workpiece handler 60 to the workpiece stage 20.

In Step 103, as the operation of starting the suction for the workpiece W, the clamp 41 located at the initial position is closed. At that time, the clamp mechanism 40 executes the operation of closing the clamp 41 all at once. In other words, the clamp 41 executes the operation of coming into contact with the workpiece W and pressing the workpiece W against the elastic seal member 22 all at once.

Fig. 6A shows a state before the workpiece W placed on the workpiece stage 20 is clamped. Here, the workpiece W is warped, and the workpiece W and the elastic seal member 22 are not in contact. In other words, a gap is generated between the workpiece W and the elastic seal member 22. In such a state, air is drawn through the gap even if the recess 29 of the suction section 21 is evacuated, which makes it impossible to increase the degree of vacuum (decrease the pressure).

On the other hand, Fig. 6B shows a state after the workpiece W placed on the workpiece stage 20 is clamped. Here, the workpiece W is pressed downward by the clamp 41 to come into contact with the elastic seal member 22, so that the gap shown in Fig. 6A is eliminated. With this state, vacuum leakage from the gap does not occur even if the recess 29 of the suction section 21 is evacuated, which makes it possible to easily increase the degree of vacuum and to properly vacuum-suction the workpiece W.

In Step 103, the closing operation of closing the clamp 41 of the clamp mechanism 40 described above (Step 103A), the operation of starting the suction for the workpiece W by the suction section 21 (Step 103B), and the operation of releasing the suction for the workpiece W by the loading workpiece handler 60 (Step 103C) are executed.

Those operations are almost simultaneously executed, but description will be given here assuming that Steps 103A, 103B, 103C are executed in the stated order. For example, the workpiece W is placed on the suction surface 24 with the suction section 21 being evacuated. When the clamp 41 is closed at the timing at which the workpiece W is placed (Step 103A), the gap is eliminated on the back surface of the workpiece W, and the suction for the workpiece W is started (Step 103B). Additionally, after the workpiece W is placed, evacuation for the suction pads of the loading workpiece handler 60 is stopped to release the suction (Step 103C). In such a manner, the three operations are almost simultaneously executed, which makes it possible to shorten the takt time satisfactorily.

Note that Steps 103A, 103B, and 103C may be individually executed at time intervals. Additionally, the order in which each operation is executed is also not limited. For example, after the workpiece W is placed, the suction by the loading workpiece handler 60 may be released (Step 103C), the evacuation for the suction section 21 may be started (Step 103B), and finally the closing operation of closing the clamp 41 may be performed (Step 103A). In addition to the above, Steps 103A to 103C can be executed in any order.

In any case, in the workpiece stage 20, the clamp 41 is closed when the workpiece W is suctioned, which prevents the generation of a gap between the workpiece W and the elastic seal member 22. This makes it possible to complete the vacuum suction for the workpiece W in a short time.

Upon execution of Step 103, the process of raising the loading workpiece handler 60, which has released the suction, is executed (Step 104). Here, the loading workpiece handler 60 is raised and then moved to a predetermined retracting position from the position above the loading position.

Next, it is determined whether or not the suction for the workpiece W has been completed in the workpiece stage 20 (Step 105). For example, the degree of vacuum of the suction section 21 (the recess 29) is detected by the suction sensor 23 shown in Fig. 1, and whether or not the degree of vacuum has reached a predetermined value is determined. If the degree of vacuum has not reached a predetermined value (No of Step 105), it is determined that the vacuum suction has not been completed, and Step 105 is executed again to determine the degree of vacuum again. Additionally, if the degree of vacuum has reached a predetermined value (Yes of Step 105), it is determined that the vacuum suction has been completed, and Step 106 is executed.

In the state in which the vacuum suction has been completed, the workpiece W remains clamped. In this state, a pressing force acts on the workpiece W from the clamp 41. If the workpiece W is being pressed continuously by the clamp 41 in such a manner after the completion of the vacuum suction, that force may reduce the flatness of the workpiece W.

For example, the workpiece W is pushed downward more than necessary by the clamp 41. This may deform the workpiece W, which is originally held flat. For example, in a configuration in which the workpiece W is pressed on the upper part of the elastic seal member 22, the workpiece W is likely to sink and to be deformed.

Additionally, the suction plate 27 constituting the suction surface 24 is a relatively thin member. Therefore, when the force to press the workpiece W reaches the suction plate 27, the suction plate 27 may be deformed. For example, when the clamp 41 presses the workpiece W on the inside of the elastic seal member 22, both the workpiece W and the suction plate 27 may be deformed.

By the way, in the state in which the vacuum suction for the workpiece W is completed, the workpiece W can be satisfactorily fixed to the workpiece stage 20 without clamping the workpiece W. In other words, even if the clamp 41 is released, the workpiece W is held flat along the suction surface 24. Separating the clamp 41 from the workpiece W can eliminate the deformation of the workpiece W or the suction surface 24 due to the clamp 41 and can hold the workpiece W with a high degree of flatness.

However, in the apparatus such as the exposure apparatus 100, a lens or the like of the projection optical system 13 is closely disposed immediately above the workpiece W. Additionally, an alignment camera or the like for positioning of a stage (workpiece W) and an optical system may be provided between the workpiece W and the projection optical system 13. Therefore, when the workpiece W is subjected to exposure, the space above the workpiece stage 20 is a narrow space with limited spacing from other components. If the clamp 41 is completely opened in such a narrow space, the clamp 41 may collide with the lens of the projection optical system 13, the alignment camera, etc., and the exposure apparatus 100 may be damaged.

In this regard, in this embodiment, when the workpiece W is subjected to exposure, the clamp 41 is separated from the workpiece W to the intermediate position (first opening operation), and after the exposure for the workpiece W is completed and the workpiece stage 20 is moved to the unloading position, the clamp 41 is moved to the initial position (second opening operation). At that time, the intermediate position is set to a position at which the clamp 41 does not collide with other members during the exposure.

In such a manner, in the clamp mechanism 40, the first opening operation is executed before the exposure process is executed. Additionally, after the exposure process is executed, the second opening operation is executed. By the first opening operation, the clamp 41 is opened during the exposure for the workpiece W, which makes it possible to perform exposure with a high degree of flatness of the workpiece W. Additionally, since the clamp 41 is not completely opened during the exposure, the clamp 41 does not come into contact with other members and damage the apparatus. This makes it possible to achieve high-precision exposure in safety.

Returning to Fig. 5, in Step 106, it is determined that the vacuum suction for the workpiece W has been completed, and the first opening operation of opening the clamp 41 to the intermediate position is executed. This operation can also be an operation of opening the clamp 41 slightly, as compared to the case where the clamp 41 is opened to the initial position. In such a manner, in this embodiment, the clamp mechanism 40 executes the first opening operation on the basis of a signal indicating that the suction for the workpiece W is completed by the suction section 21 (for example, a detection signal of the suction sensor 23). This can avoid a situation in which the clamp 41 is opened before the suction for the workpiece W is completed.

Note that, in Fig. 5, the first opening operation is executed when it is determined that the suction for the workpiece W is completed, but the first opening operation may be executed, for example, when a predetermined period of time has elapsed from the start of the suction for the workpiece W. Additionally, the timing at which the first opening operation is performed may be immediately before the exposure process is performed. In other words, the first opening operation may be performed after the workpiece stage 20 is moved to the exposure position. In this case, the first opening operation may be executed on the basis of a signal indicating the start of the exposure process for the workpiece W. In any case, the clamp 41 is reliably moved to the intermediate position during the exposure, so that the high-precision exposure can be performed.

Fig. 6C shows a state in which the clamp 41 is opened to the intermediate position after the completion of the vacuum suction for the workpiece W. As shown in Fig. 6C, the clamp 41 is separated from the workpiece W, but since the vacuum suction for the workpiece W is completed, the workpiece W is held flat. Note that the state shown in Fig. 6C is the same as the state of the workpiece stage 20 shown in the right part of Fig. 1.

In this embodiment, a separation distance between the clamp 41 and the workpiece W at the intermediate position is set to 1 mm or less. Here, the separation distance between the clamp 41 and the workpiece W is, for example, a distance from the tip of the contact portion 43 of the clamp 41 to the exposure surface of the workpiece W in the vertical direction (in the direction orthogonal to the suction surface 24).

Even if the separation distance is relatively small in such a case, the force acting on the workpiece W from the clamp 41 is eliminated, so that a high degree of flatness can be achieved. Additionally, the amount of change in height from the closed state of the clamp 41 (clamp position) is 1 mm at most. This makes it possible to satisfactorily avoid a collision between the clamp 41 and the member disposed in the narrow space above the workpiece stage 20. Additionally, a limited distance that is set so as not to collide with the clamp 41 (for example, a distance from the suction surface 24 to the lens) can be relatively shortened. Thus, it is also possible to use, for example, an optical system with a shallow depth of focus that enables high-resolution exposure.

Referring back to Fig. 5, when Step 106 is completed and the clamp 41 is opened to the intermediate position, the process of moving the workpiece stage 20 to the exposure position is executed (Step 107). In this case, the workpiece stage 20 is transported by the moving mechanism from the loading position of the workpiece W to the exposure position below the projection optical system 13.

When the workpiece stage 20 is moved to the exposure position, the exposure process is started (Step 108). In the exposure process, the alignment, focusing, or the like of the workpiece W and the projection optical system 13 is performed, for example, using the alignment camera or the like. Subsequently, the exposure surface of the workpiece W is irradiated with exposure light that has passed through the mask M.

Additionally, if the size of the workpiece W is large, for example, the above steps are performed multiple times while changing the exposure range. In this case, the workpiece stage 20 and a portion of the exposure apparatus 100 other than the workpiece stage are moved relative to each other and moved to a plurality of exposure ranges. During this time, the clamp 41 is maintained in the opened state at the intermediate position.

Next, it is determined whether or not the exposure for the workpiece W has been completed (Step 109). For example, if the exposure is completed at one time, a signal indicating the exposure completion is determined. Additionally, if the exposure is performed multiple times, the number of times of exposure is determined. If it is determined that the exposure has not been completed (No of Step 109), Step 109 is executed again to determine whether or not the exposure is completed. If it is determined that the exposure has been completed (Yes of Step 109), Step 111 is executed.

Note that during the exposure process in Steps 108 and 109, the process of moving the unloading workpiece handler 60, which unloads the workpiece W, above the unloading position is executed concurrently (Step 110). The unloading workpiece handler60 waits above the unloading position in the state capable of holding the workpiece W.

In Step 111, the process of moving the workpiece stage 20 to the unloading position of the workpiece W is executed. In this case, the workpiece stage 20 is transported by the moving mechanism from the exposure position to the unloading position. Next, the process of lowering the unloading workpiece handler 60 is executed (Step 112). The unloading workpiece handler 60 is lowered to a position at which the workpiece W can be suctioned.

Next, while starting the suction for the workpiece W by the unloading workpiece handler 60, the process of releasing the suction for the workpiece W by the workpiece stage 20 is executed (Step 113). This is an operation of delivering the workpiece W from the workpiece stage 20 to the unloading workpiece handler 60.

In Step 113, the second opening operation of opening the clamp 41, which has been opened to the intermediate position, to the initial position is executed as the operation of releasing the suction for the workpiece W. In such a manner, the clamp mechanism 40 executes the second opening operation when the workpiece W is moved away from the exposure position of the exposure section 10 (the optical system of the exposure apparatus 100 including the projection optical system 13) after the exposure process for the workpiece W is executed.

Since the workpiece W (the workpiece stage 20) is moved away from the exposure position, the clamp 41 can be opened to the initial position without colliding with other members. Note that in Step 113 the clamp 41 is opened to the initial position after being moved to the unloading position, but the position at which the second opening operation is to be performed is not necessarily the unloading position as long as a collision with the lens, the alignment camera, or the like does not occur.

Note that the operation of starting the suction for the workpiece W by the unloading workpiece handler 60 (Step 113A), the operation of releasing the suction for the workpiece W by the suction section 21 (Step 113B), and the above-mentioned second opening operation of opening the clamp 41 to the initial position (Step 113C) are executed in Step 113.

Those operations are almost simultaneously executed, but description will be given here assuming that Steps 113A, 113B, and 113C are executed in the stated order. For example, the suction pads 61 of the unloading workpiece handler 60 come into contact with the exposure surface of the workpiece W in the state of evacuation, and the suction for the workpiece W is started (Step 113A). Additionally, at the timing at which the unloading workpiece handler 60 comes into contact with the workpiece W, evacuation for the suction section 21 is stopped and air is injected through the piping L (Step 113B). Additionally, the clamp 41 located at the intermediate position at the same timing is opened to the initial position (Step 113C). This makes it possible to unload the workpiece W from the workpiece stage 20.

Note that Steps 113A, 113B, and 113C may be individually executed at time intervals. Additionally, the order in which each operation is executed is also not limited. For example, after the clamp 41 is opened to the initial position (Step 113C), the suction for the workpiece stage 20 may be released (Step 113B), and finally the evacuation for the unloading workpiece handler 60 may be started (Step 113A). In addition to the above, Steps 113A to 113C can be executed in any order.

Fig. 6D shows a state in which the suction for the workpiece W is released and the clamp 41 is opened to the initial position. Here, the workpiece W is warped as in the case of Fig. 6A, and a gap is generated between the workpiece W and the elastic seal member 22. Note that it is unnecessary to perform suction on the workpiece stage 20 after Step 113, and thus such a gap is not problematic.

Referring back to Fig. 5, it is determined whether or not the suction for the workpiece W in the unloading workpiece handler 60 has been completed (Step 114). For example, the degree of vacuum of the vacuum suction is detected by a pressure sensor or the like provided to the unloading workpiece handler 60, and it is determined whether or not the degree of vacuum has reached a predetermined value. If the degree of vacuum has not reached a predetermined value (No of Step 114), it is determined that the vacuum suction has not been completed, and Step 114 is executed again to determine the degree of vacuum again.

If the degree of vacuum has reached a predetermined value (Yes of Step 114), it is determined that the vacuum suction has been completed, and the process of raising the unloading workpiece handler 60 is executed (Step 115). Thus, the workpiece W is unloaded from the workpiece stage 20. The unloading workpiece handler 60 moves while holding the workpiece W by suction, and transports the workpiece W for the next step. The processes up to here complete one exposure sequence.

In recent years, along with the miniaturization of devices, finer line width patterns are requested as patterns to be formed on a workpiece W by the exposure process. For example, in projection aligners, a lens that projects a pattern is requested to have high resolving power. For this reason, lenses with a large numerical aperture (NA) are employed, but on the other hand, the depth of focus becomes shallower, and a higher degree of flatness is required for a workpiece W subjected to exposure.

On the stage on which the workpiece W is placed, for example, the workpiece W is suctioned onto a high-flatness suction plate to improve the flatness of the workpiece W. Additionally, when the workpiece W is suctioned, the workpiece W can be clamped to assist the suction.

However, in a state in which the workpiece W is clamped onto the suction plate, the workpiece W may be deformed by a clamping force of the clamp (for example, approximately 100 N per side of the workpiece W). In this case, for example, part of the workpiece W floats from the suction plate, making it impossible to hold the workpiece W with a high degree of flatness. Especially when the workpiece W is thin (e.g., about 0.2 mm thick), the deformation of the workpiece W by the clamp becomes more pronounced. Additionally, the clamping force of the clamp may also deform the suction plate, which may make it impossible to maintain the workpiece W with a high degree of flatness.

It is conceived that the clamp is opened in order to eliminate such deformation of the workpiece W caused by the clamp. On the other hand, the distance between the stage and the projection lens is short, and an alignment camera or the like may also be provided, and thus the clamp may collide with those members when the clamp is opened.

In this embodiment, the clamp mechanism 40 is configured so as to perform the operation of opening the clamp 41 in two steps. Thus, the clamp 41 located at the clamp position (see Fig. 6B) is first opened to the intermediate position (see Fig. 6C) and then opened to the initial position (see Fig. 6D). The intermediate position is appropriately set such that the clamp 41 does not collide with other members.

This makes it possible to perform the exposure process in a state in which the clamp 41 is separated from the workpiece W to the intermediate position. In other words, this makes it possible to perform the exposure process while maintaining a high degree of flatness without providing a clamping force to the workpiece W and the suction plate 27, after the workpiece W is held by suction onto the suction plate 27 (the workpiece stage 20).

In such a manner, the influence of the force of the clamp 41 is eliminated, and the workpiece W and the suction plate 27 are provided with a high degree of flatness during the exposure process, so that fine exposure can be achieved. This makes it possible to achieve the process of exposing a high-resolution pattern using a lens with a high resolving power (high resolving power exposure process) with high accuracy and safety.

Hereinafter, in the workpiece stage 20 according to this embodiment, the elastic seal member 22 is provided around the suction surface 24 on which the workpiece W is vacuum-suctioned, and the workpiece W is pressed so as to come into contact with the elastic seal member 22 by the clamp 41 of the clamp mechanism 40 when the workpiece W is suctioned. This makes it possible to prevent the generation of a gap that inhibits vacuum suction for the workpiece W and to properly vacuum-suction various workpieces W.

Additionally, in the workpiece stage 20 according to this embodiment, the operation of opening the clamp 41 is executed in two steps. For example, the first opening operation of opening the clamp 41 to the intermediate position is executed before the exposure process is executed. This makes it possible to avoid a collision of the clamp 41 with other components and maintain the flatness of the workpiece W at a high level during the exposure process. As a result, it is possible to achieve high-resolution exposure safely.

### Other Embodiments

The present invention is not limited to the embodiment described above and can achieve various other embodiments.

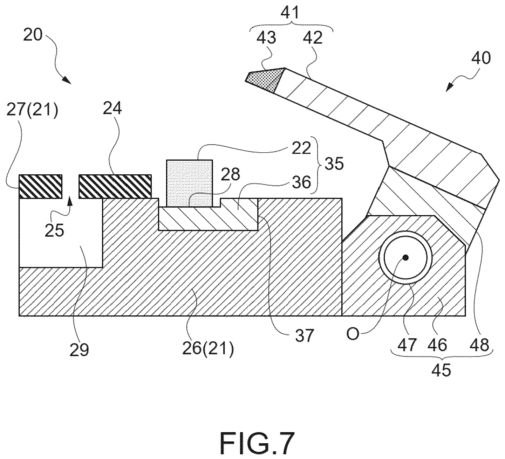

Fig. 7 is a schematic view showing a configuration example of a seal unit that includes an elastic seal member. A seal unit 35 includes an elastic seal member 22 and a plate member 36 on which the elastic seal member 22 is placed. An attaching section 28 to which the lower surface of the elastic seal member 22 is attached is formed on the upside surface of the plate member 36. The elastic seal member 22 and the plate member 36 are fixed, for example, using an adhesive or the like. Additionally, a groove 37 into which the plate member 36 is fitted is formed on the upper side of the base 26. The plate member 36 is fixed to the groove 37 by screws. Additionally, in order to suppress the vacuum leakage when the workpiece W is vacuum-suctioned on the suction plate 27 side, an O-ring or the like not shown in the figure may be provided between the plate member 36 and the base 26.

In such a manner, the seal unit 35 obtained by placing the elastic seal member 22 on the plate member 36 and unitizing them may be attached to the base 26. This makes it possible to easily replace the elastic seal member 22 by, for example, removing the seal unit 35. Note that the suction plate 27 and the seal unit 35 are configured as separate members in Fig. 7, but for example, the seal unit 35 may be connected to the outer circumference of the suction plate 27 to integrate the suction plate 27 and the seal unit 35. This makes it possible to replace the suction plate 27 and the elastic seal member 22 at one time, which facilitates the maintenance of the apparatus.

The above embodiment has described the clamp mechanism that clamps the workpiece W, which has a rectangular planar shape, along each side. The present invention is not limited to the above, and the clamp mechanism may be configured to partially clamp a corner portion of the workpiece W or the middle of each side. For example, four clamps may be provided to press the respective four corner portions of the rectangular workpiece W. Additionally, a plurality of clamps may also be disposed at intervals along each side of the workpiece W.

The above embodiment has described the clamp mechanism that rotates the clamp to be opened and closed. The operation of the clamp is not limited to the rotation operation. For example, the workpiece W may be clamped in combination of the movement in the vertical direction and the movement in the in-plane direction orthogonal to the vertical direction. In this case, for example, the following mechanism is used: the clamp is lowered when the clamp is closed, or the clamp is raised when the clamp is opened, and the clamp is then moved in the in-plane direction so as to move away from the workpiece W.

Additionally, the clamp may also be moved in an oblique direction to press the workpiece W. In this case, for example, the following mechanism is used: the clamp is brought into contact with the workpiece W from diagonally above when the clamp is closed, and the clamp is retracted diagonally above when the clamp is opened. In addition to the above, the movement in each direction such as the vertical direction, the in-plane direction, or the oblique direction (shift operation) may be combined, or the shift operation may be combined with a rotation operation.

The above embodiment has described the clamp mechanism that performs the two-step opening operation including the first opening operation and the second opening operation, but the present invention is not limited thereto. The clamp mechanism may be configured to perform opening operation divided into multiple times such as three steps or four steps. Additionally, for example, depending on the configuration of the exposure section or the like, steps (separation distance) of the opening operation performed before the exposure process may be selected. For example, in the clamp mechanism enabling the opening operations of three steps in total, it is also possible to perform the opening operation of one step before the exposure process if the space between the workpiece W and the exposure section is narrow, and to perform the opening operations of two steps before the exposure process if the space is wider.

The above embodiment has described the clamp mechanism that performs the first opening operation of operating the clamp to the intermediate position, which has a shorter separation distance than the initial position, before performing the exposure process. If the force acting on the workpiece W from the clamp can be eliminated, the clamp is not necessarily separated from the workpiece W.

For example, the pressing force of the clamp onto the workpiece W may be turned off before the exposure process is performed. For example, if an air cylinder is used as a power source, the pressure of the cylinder is reduced such that the clamp does not press the workpiece W. Additionally, if a motor or the like is used, the motor may be controlled to stop the rotation, or the power supplied to the motor may be cut.

Thus, the clamp mechanism may release the operation of pressing the workpiece W by the clamp before the suction for the workpiece W by the suction section is completed and the exposure process for the workpiece W is executed. For example, the operation of separating the clamp (first opening operation) is an example of releasing the operation of pressing the workpiece W. Additionally, the operation of turning off the force of the clamp to press the workpiece W without separating the clamp is also the operation of releasing the operation of pressing the workpiece W. In such a manner, releasing the operation of pressing the workpiece W before the exposure process makes it possible to eliminate the deformation of the workpiece W due to the clamp and perform the exposure process with a high degree of flatness.

The above embodiment has described the configuration in which the workpiece stage is provided with the elastic seal member and the clamp mechanism, but a workpiece stage without an elastic seal member may be used. In this case, the clamp mechanism is configured to, for example, directly press the workpiece W onto the suction surface from above the suction surface. Additionally, an outer circumferential surface for a clamp may be configured around the suction surface, and a workpiece W may be directly pressed against the outer circumferential surface from above the outer circumferential surface. It is favorable that the outer circumferential surface has the same height as the suction surface, but it may be configured to be one level lower than the suction surface, for example.

Even if the elastic seal member is not provided in such a manner, the workpiece W can be vacuum-suctioned onto the suction surface by pressing the workpiece W by the clamp. Note that when the vacuum suction for the workpiece W is completed, the workpiece W is held along the suction surface. If the force of the clamp acts there, the workpiece W, the suction plate constituting the suction surface, or the like may be deformed.

In order to eliminate such deformation, the operation of pressing the workpiece W by the clamp is released before the exposure process is executed. For example, the operation of separating the clamp from the workpiece W (first opening operation) or the operation of turning off the force of the clamp to press the workpiece W is executed. This makes it possible to eliminate the deformation of the workpiece W due to the clamp and perform the exposure process with a high degree of flatness even on the workpiece stage where the workpiece W is directly pressed against the suction surface or the like.

The above embodiment has mainly described the example in which the workpiece stage according to the present invention is applied to a projection aligner (mask exposure apparatus) using the mask M, but it is not limited thereto. The workpiece stage according to the present invention can also be applied to an exposure apparatus by another method. For example, the present invention may be applied to a direct imaging (DI) exposure apparatus. The DI exposure apparatus is an apparatus that exposes a workpiece W by direct lithography of a wiring pattern by scanning of laser light without using a mask. In this case, a laser light source, a modulator that modulates laser light in accordance with a pattern, a lens for applying laser light, and the like constitute an exposure section that exposes a pattern onto the workpiece W. Use of a workpiece stage including an elastic seal member and a clamp mechanism makes it possible to perform an exposure process by the DI exposure apparatus after properly suctioning various workpieces W.

Additionally, also in the DI exposure apparatus, the resolving power of the optical system needs to be increased to achieve finer exposure patterns. Specifically, the numerical aperture (NA) of a lens through which laser light is applied is to be increased in order to reduce the spot diameter of the lithography. On the other hand, increasing the numerical aperture may result in a shallower depth of focus (narrower working distance). Thus, if the flatness of the workpiece W during the exposure process is low, there is a possibility that a desired exposure accuracy is not obtained.

In contrast to the above, in the workpiece stage according to the present invention, for example, the first opening operation is executed before the exposure process, and the state in which the workpiece W is pressed by the clamp is released. This makes it possible to perform the exposure process while maintaining a high degree of flatness without providing a clamping force to the workpiece W or the suction plate. Additionally, for example, the second opening operation of opening the clamp to the initial position is executed when the workpiece W is moved away from the exposure position of the DI exposure apparatus. Thus, a situation in which the clamp collides with the lens through which laser light is applied, or the like, can be satisfactorily avoided. This makes it possible to safely achieve high-resolution exposure using the DI exposure apparatus.

The above embodiment has mainly described the exposure process of exposing the workpiece W, but the present invention is not limited thereto. The present invention can be applied to any processing performed with the flatness of the workpiece W being maintained. Examples of such processing include a film deposition process of generating a thin film, made of a metal material, a semiconductor material, a resin material, or the like, on the surface of a workpiece W, an etching process of scraping the surface of the workpiece W. Additionally, the present invention may also be applied to a workpiece stage used in machine processing, laser processing, or the like. In addition to the above, the type of processing is not limited.

At least two of the features among the features described above according to the present technology can also be combined. In other words, various features described in the embodiments may be combined discretionarily regardless of the embodiments. Further, the various effects described above are merely illustrative and not restrictive, and other effects may be exerted.

It should be understood by those skilled in the art that various modifications, combinations, sub-combinations and alterations may occur depending on design requirements and other factors insofar as they are within the scope of the appended claims or the equivalents thereof.

## Claims

1. A holding mechanism, comprising:
a suction section (21) having a suction surface (24) on which a workpiece is to be vacuum-suctioned;
an elastic seal member (22) disposed around the suction surface (24) such that at least part of the elastic seal member (22) is hidden by the workpiece in plan view when the suction surface (24) is viewed from above; and
a clamp mechanism (40) that
includes a clamp (41) that presses the workpiece such that the workpiece comes into contact with the elastic seal member (22), and
drives the clamp (41) to press the workpiece when the workpiece is suctioned by the suction section (21).

2. The holding mechanism according to claim 1, wherein
the clamp (41) presses the workpiece at a position at which the workpiece and the elastic seal member (22) overlap with each other in plan view.

3. The holding mechanism according to claim 1, wherein
the workpiece and the elastic seal member (22) each have a rectangular planar shape, and
the clamp (41) presses the workpiece along at least one side of four sides of the workpiece, the four sides being outer edges of the workpiece.

4. The holding mechanism according to claim 1, wherein
the clamp mechanism (40) releases an operation of the clamp (41) to press the workpiece after suction for the workpiece by the suction section (21) is completed and before processing is performed on the workpiece.

5. The holding mechanism according to any one of claims 1 to 4, wherein
the clamp mechanism (40) is a mechanism that opens and closes the clamp (41) to press the workpiece, and executes an operation of opening the clamp (41) in at least two steps.

6. The holding mechanism according to claim 5, wherein
the operation of opening the clamp (41) includes
a first opening operation of moving the clamp (41) to a first position distant from the workpiece, and
a second opening operation of moving the clamp (41) to a second position more distant than the first position.

7. The holding mechanism according to claim 6, wherein
the clamp mechanism (40) executes the first opening operation after suction for the workpiece by the suction section (21) is completed and before processing is performed on the workpiece, and executes the second opening operation after the processing is executed.

8. The holding mechanism according to claim 7, wherein
the clamp mechanism (40) executes the first opening operation on a basis of a signal indicating that the suction for the workpiece by the suction section (21) is completed or a signal indicating that the processing for the workpiece is started.

9. The holding mechanism according to claim 7, wherein
the processing is an exposure process of exposing the workpiece by an exposure section (10) that exposes a pattern onto the workpiece, and
the clamp mechanism (40) executes the second opening operation when the workpiece is moved away from an exposure position of the exposure section (10) after the exposure process is performed on the workpiece.

10. The holding mechanism according to claim 6, wherein
a separation distance between the clamp (41) and the workpiece at the first position is 1 mm or less.

11. The holding mechanism according to claim 5, wherein
the clamp mechanism (40) executes an operation of closing the clamp (41) all at once.

12. The holding mechanism according to claim 1, wherein
the suction section (21) includes a circumferential section (28) that surrounds the suction surface (24) and is formed to be lower in level than the suction surface (24), and
the elastic seal member (22) is disposed in the circumferential section (28).

13. The holding mechanism according to claim 1, wherein
the suction section (21) includes
a base (26) including a recess (29) that supplies vacuum and a plurality of protrusions (30) formed in the recess (29), and
a suction plate (27) including a plurality of through-holes (25) and forming the suction surface (24) by being attached above the recess (29).

14. An exposure apparatus, comprising:
an exposure section (10) that exposes a pattern onto a workpiece; and
a workpiece stage (20) that includes
a suction section (21) having a suction surface (24) on which the workpiece is to be vacuum-suctioned,
an elastic seal member (22) disposed around the suction surface (24) such that at least part of the elastic seal member (22) is hidden by the workpiece in plan view when the suction surface (24) is viewed from above, and
a clamp mechanism (40) that
includes a clamp (41) that presses the workpiece such that the workpiece comes into contact with the elastic seal member (22), and
drives the clamp (41) to press the workpiece when the workpiece is suctioned by the suction section (21).

15. The exposure apparatus according to claim 14, wherein
the exposure section (10) includes
a light emission section (11) that emits exposure light,
a mask stage (12) that holds a mask on which the pattern is formed, on an optical path of the exposure light, and
a projection optical system (13) that projects the exposure light onto the workpiece, the exposure light having passed through the mask.
